# EUROPÄISCHE PATENTANMELDUNG

(11) **EP 1 424 733 A2**
(43) Veröffentlichungstag der Anmeldung: **02.06.2004**
(21) Anmeldenummer: 03027411.2
(22) Anmeldetag: 27.11.2003
(51) Int. Cl.: H01L 27/02

(54) **Verfahren und Vorrichtung zum Anordnen von Kontaktierungselementen von Bauelementen eines integrierten Schaltkreises, Computerlesbares Speichermedium und Programm-Element**

(30) Priorität: 28.11.2002 DE 10255626
(71) Anmelder: Infineon Technologies AG, 81669 München (DE)
(72) Erfinder: Mono, Tobias, 01099 Dresden (DE); Schröder, Uwe Paul, 01465 Langebrück (DE)
(74) Vertreter: Viering, Jentschura & Partner

(57) **Zusammenfassung**

Die Erfindung betrifft ein Verfahren und eine Vorrichtung zum Anordnen von Kontaktierungselementen von Bauelementen eines integrierten Schaltkreises, ein Computerlesbares Speichermedium und ein Programm-Element. Bei dem Verfahren zum Anordnen von Kontaktierungselementen von Bauelementen eines integrierten Schaltkreises, wobei zumindest ein Teil von zumindest einem Bauelement entlang einer ersten Verlaufsrichtung eine größere Ausdehnung aufweist als entlang einer zu der ersten Verlaufsrichtung orthogonalen zweiten Verlaufsrichtung, und wobei zumindest ein einem Bauelement zugeordnetes Kontaktierungselement im Querschnitt entlang einer dritten Verlaufsrichtung eine größere Ausdehnung aufweist als entlang einer zu der dritten Verlaufsrichtung orthogonalen vierten Verlaufsrichtung, wird das Kontaktierungselement bezüglich des zugeordneten Bauelements derart angeordnet, dass die erste Verlaufsrichtung des Bauelements zu der dritten Verlaufsrichtung des Kontaktierungselements im Wesentlichen parallel verläuft.

## Beschreibung

Die Erfindung betrifft ein Verfahren und eine Vorrichtung zum Anordnen von Kontaktierungselementen von Bauelementen eines integrierten Schaltkreises, ein Computerlesbares Speichermedium und ein Programm-Element.

Mit weiter voranschreitender Miniaturisierung in der Silizium-Mikroelektronik steigen auch die Anforderungen an hierbei verwendete Lithographieverfahren.

Die Aufgabe eines Lithographie-Verfahrens besteht darin, eine Vielzahl von Resist-Strukturen auf einem Silizium-Wafer maßgetreu, lagerichtig und defektfrei zu erzeugen. Kriterien für die Leistungsfähigkeit eines Lithographie-Verfahrens sind die minimal erreichbaren Strukturgröße, die Linienbreitenstreuung, die Lagefehlerstreuung sowie die Defektdichte. Insbesondere die minimal erreichbare Strukturdimension ("critical dimension", CD) ist im Hinblick auf eine erwünschte hohe Integrationsdichte wesentlich.

Unter anderem wird eine Lithographiemaske dazu verwendet, eine Anordnung von prozessierten integrierten Bauelementen eines Siliziumchips elektrisch zu kontaktieren. Hierfür wird ein zu kontaktierendes Bauelement mit einem elektrisch leitfähigen Kontaktierungselement elektrisch gekoppelt, wobei das Kontaktierungselement häufig einen quadratischen Querschnitt aufweist. Mit verringerter Strukturdimension eines integrierten Schaltkreises wird auch die Seitenlänge des Kontaktierungselements auf immer geringere Dimensionen skaliert, wobei eine Verringerung einer Seitenlänge eines quadratischen Kontaktierungselements quadratisch in eine Verringerung der Querschnittsfläche eingeht.

Insbesondere bei Kontaktierungselementen geringer Strukturdimensionen werden aus diesem Grund häufig Kontaktierungselemente mit rechteckförmiger Querschnittsfläche verwendet. Es ist vorteilhaft, bei der rechteckförmigen Querschnittsfläche des Kontaktierungselements ein Verhältnis der Seitenlängen von 1.5 und mehr zu verwenden. Dies führt abhängig von der Strukturdimension und der Steuerungsmöglichkeit der Belichtung der Maske dazu, dass der Querschnitt der Kontaktierungselemente häufig im Wesentlichen rund oder elliptisch ist.

Ein Nachteil ist die Verringerung der Steuerbarkeit der kritischen Strukturdimension ("critical dimension control") entlang derjenigen Ausdehnungsrichtung des Kontaktierungselements mit rechteckigem Querschnitt, entlang welcher die längere Seitenkante des Rechteck-Querschnitts verläuft. Entlang dieser Richtung ist der Platzbedarf des Kontaktierungselements größer als in der zu dieser Richtung orthogonalen Richtung, was zu einem hohen Platzbedarf des kontaktierten Bauelements führen kann.

Bei der Random-Logik-Schaltkreisarchitektur tritt in einem integrierten Schaltkreis häufig eine Abfolge von integrierten Bauelementen auf, die hochgradig örtlich unsymmetrisch angeordnet sind und sich oft nicht als sich wiederholende Anordnung bestimmter Bausteine oder Bausteingruppen (wie zum Beispiel im Falle eines Speicher-Schaltkreises) darstellt. Aufgrund dieser komplexen und auf einer Anordnung vieler unterschiedlicher Bauelemente beruhenden Schaltungsarchitektur kann beim Design von Random-Logik-Schaltkreisen ein Minimal-Abstand eines Kontakts beispielsweise zu einer Polysilizium-Leitung in jeder beliebigen Richtung auf einem Substrat auftreten, in dem der Schaltkreis integriert ist. Daher ist es bei Random-Logik-Schaltkreisen erforderlich, dass die Steuerung der kritischen Strukturdimension in beiden zueinander orthogonalen Verlaufsrichtungen auf einem Substrat ausreichend gut ist. Somit ist es bei Random-Logik-Schaltkreisen häufig schwierig, die Anordnung von Kontaktierungselementen zu gestalten, da aufgrund der unsymmetrischen Struktur eines Random-Logik-Schaltkreises für jedes seiner Bauelemente die Anordnung der Kontaktierungselemente separat vorzunehmen ist. Daher ist es schwierig, bei Random-Logik-Schaltkreisen einen geringen Mitte-Mitte-Abstand benachbarter Bauelemente und folglich eine platzsparende Layout-Architektur zu erreichen. Als Beispiel für einen Schaltkreis mit zu kontaktierenden Bauelementen ist eine Anordnung von CMOS-Transistoren zu nennen, deren Diffusionsgebiete mittels eines Kontaktierungselements kontaktiert werden.

Aus dem Stand der Technik sind eine Reihe von Möglichkeiten bekannt, die Dimension eines Kontaktierungselements und daher die Dimension von dessen Querschnittsfläche zu verringern.

Bei Verwendung einer optischen Lithographie mit einer verringerten Lichtwellenlänge (beispielsweise 193nm) wird die erreichbare Strukturdimension verringert. Allerdings ist eine Lithographie unter Verwendung solch kurzwelliger Strahlung aufwändig und führt zu stark erhöhten Herstellungskosten.

Bei der Verwendung von Kontaktierungselementen mit rechteckförmigem Querschnitt, zum Beispiel in Speicherzellen-Schaltkreisen, wird in der Ausdehnungsdimension des rechteckförmigen Querschnitts mit der längeren Rechteckseite der Mitte-Mitte-Abstand benachbarter Bauelemente erhöht, da die kritische Strukturdimensions-Steuerung entlang der langen Achse herabgesetzt wird. Dies führt unerwünschterweise zu einem erhöhten Flächenbedarf auf dem Chip.

Ferner sind andere Verfahren bekannt, mit denen die Ausdehnung von Kontaktierungselementen verringert werden kann, wie das CARL™-Verfahren, das RELACS™-Verfahren oder das Resist-Reflow-Verfahren.

Bei dem in [1] beschriebenen CARL™-Verfahren ("chemical amplification of resist lines") wird auf einem Substrat zunächst eine dicke, herkömmliche Resist-Schicht abgeschieden und darauf eine dünne sogenannte CARL-Schicht abgeschieden. Die CARL-Schicht wird strukturiert, und nachfolgend wird chemisch die laterale Ausdehnung der nach dem Strukturierungsverfahren zurückbleibenden CARL-Strukturen verbreitert und daher die laterale Ausdehnung der zwischen benachbarten CARL-Strukturen angeordneten Kontaktlöcher verringert.

Gemäß dem in [2] beschriebenen RELACS™-Verfahren ("resolution enhancement lithography assisted by chemical shrink") wird eine herkömmlich strukturierte Photoresist-Schicht mit einer RELACS™-Schicht überzogen. Mittels einer chemischen Reaktion an der Grenzfläche zwischen der herkömmlich strukturierten Photoresist-Schicht und dem darauf aufgebrachten RELACS-Material wird die laterale Ausdehnung der von dem Photoresist-Material freien Oberfläche verringert, wodurch die laterale Dimension der Kontaktlöcher verringert ist.

Allerdings weisen die beschriebenen chemischen Verfahren zum Ausbilden von Kontaktlöchern mit verringerter Strukturdimension den Nachteil einer hohen Prozesskomplexität und hoher Kosten auf. Ferner ist die Steuerung der kritischen Strukturdimension aufgrund des Einführens zusätzlicher Verfahrensschritte verschlechtert.

[3] offenbart ein Verfahren zum Gestalten von Strukturen eines integrierten Halbleiterschaltkreises.

[4] offenbart Dünnschichttransistoranzeigevorrichtungen mit koplanaren Gate- und Drain-Leitungen.

[5] offenbart ein Verfahren zum Herstellen von Kontaktlöchern unter Verwendung eines Bildverkürzungseffekts.

Der Erfindung liegt das Problem zugrunde, eine Möglichkeit zu schaffen, in einem integrierten Schaltkreis die Kontaktierung von Bauelementen mit Kontaktierungselementen derart vorzusehen, dass die Fläche des Wafers besser genutzt werden kann.

Das Problem wird durch ein Verfahren und eine Vorrichtung zum Anordnen von Kontaktierungselementen von Bauelementen eines integrierten Schaltkreises, durch ein Computerlesbares Speichermedium und durch ein Programm-Element mit den Merkmalen gemäß den unabhängigen Patentansprüchen gelöst.

Bei dem erfindungsgemäßen Verfahren zum Anordnen von Kontaktierungselementen von Bauelementen eines integrierten Schaltkreises weist zumindest ein Teil von zumindest einem Bauelement entlang einer ersten Verlaufsrichtung eine größere Ausdehnung auf als entlang einer zu der ersten Verlaufsrichtung orthogonalen zweiten Verlaufsrichtung. Zumindest ein einem Bauelement zugeordnetes Kontaktierungselement weist im Querschnitt entlang einer dritten Verlaufsrichtung eine größere Ausdehnung auf als entlang einer zu der dritten Verlaufsrichtung orthogonalen vierten Verlaufsrichtung. Gemäß dem Verfahren wird das Kontaktierungselement bezüglich des zugeordneten Bauelements derart angeordnet, dass die erste Verlaufsrichtung des Bauelements zu der dritten Verlaufsrichtung des Kontaktierungselements im Wesentlichen parallel verläuft.

Ferner ist eine Vorrichtung zum Anordnen von Kontaktierungselementen von Bauelementen eines integrierten Schaltkreises geschaffen, mit einem Prozessor, der derart eingerichtet ist, dass er einen Verfahrensschritt entsprechend des erfindungsgemäßen Verfahrens durchführen kann.

Darüber hinaus ist ein Computerlesbares Speichermedium geschaffen, in dem ein Programm gespeichert ist, das, wenn es von einem Prozessor ausgeführt wird, den Verfahrensschritt des erfindungsgemäßen Verfahrens durchführen kann.

Ferner ist ein Programm-Element zum Anordnen von Kontaktierungselementen von Bauelementen eines integrierten Schaltkreises bereitgestellt, das, wenn es von einem Prozessor ausgeführt wird, einen Verfahrensschritt gemäß dem Verfahrensschritt des erfindungsgemäßen Verfahrens aufweist.

Anschaulich wird bei dem erfindungsgemäßen Verfahren und bei der erfindungsgemäßen Vorrichtung zum Anordnen von Kontaktierungselementen von Bauelementen eines integrierten Schaltkreises bzw. bei dem Computerlesbaren Speichermedium und dem Programm-Element gemäß der Erfindung eine geometrische Anordnung von elektrischen Kontaktierungselementen von Bauelementen eines integrierten Schaltkreises, vorzugsweise rechnergestützt, ermittelt. Das mindestens eine einem Bauelement zugeordnete Kontaktierungselement weist dabei anschaulich eine Längsstruktur auf, das heißt, dass seine Ausdehnung entlang zweier zueinander orthogonaler Verlaufsrichtungen unterschiedlich groß ist. Zum Beispiel kann das Kontaktierungselement einen im Wesentlichen rechteckigen Querschnitt mit unterschiedlich langen Rechteckseiten, einen ellipsenförmigen Querschnitt mit deutlich unterschiedlich langen Hauptachsen, etc. aufweisen.

Das dem mindestens einen Kontaktierungselement zugeordnete Bauelement, von dem ein Bereich, d.h. eine Bauelement-Komponente, mittels mindestens eines Kontaktierungselements elektrisch zu kontaktieren ist, weist ebenfalls eine Längsstruktur auf. Beispielsweise kann auch das Bauelement (oder ein Teil davon) im Wesentlichen rechteckförmig mit unterschiedlich langen Rechteckseiten ausgebildet sein. Zum Beispiel kann die Bauelement-Komponente eine Gate-Leitung zum Ansteuern des Gate-Bereichs eines Feldeffekttransistors sein.

Indem anschaulich die längere Verlaufsrichtung des Kontaktierungselements parallel zu der längeren Verlaufsrichtung des kontaktierten Bauelements angeordnet wird, ist ein ausreichend sicheres Kontaktieren des Bauelements ermöglicht und simultan zumindest in einer Dimension die Kontaktlochausdehnung verringert. Somit ist der Platzbedarf auf einem Halbleiterchip gering gehalten, was der Tendenz zur fortschreitenden Miniaturisierung von integrierten Schaltkreisen entgegenkommt. Anschaulich werden die Verlaufsrichtungen des Bauelements und des Kontaktierungselements mit strukturell großer Ausdehnung zueinander parallel gewählt, so dass in der dazu orthogonalen Richtung die Ausdehnung der Anordnung gering gehalten ist.

Diese Vorteile werden erfindungsgemäß erreicht, ohne dass eine erhöhte Wiederhol-Länge von Bauelementen, das heißt ein erhöhter Mitte-Mitte-Abstand zwischen benachbarten Bauelementen, auftritt. Im Gegenteil, die verringerte Ausdehnung des Kontaktierungselements bewirkt einen weiter verringerten Mitte-Mitte-Abstand zwischen benachbarten Bauelementen und ermöglicht daher eine fortgesetzte Reduktion der Chipgröße bzw. eine effektive Nutzung der auf einem Chip zur Verfügung stehenden aktiven Fläche. Mit anderen Worten werden kleinere Kontaktlöcher geschaffen, ohne dass dies eine negative Auswirkung auf die Chipgröße hat.

Die Erfindung kann sowohl mittels eines Computerprogramms, d.h. einer Software, als auch mittels einer oder mehrerer spezieller elektrischer Schaltungen, d.h. in Hardware, oder in beliebig hybrider Form, d.h. mittels Software-Komponenten und Hardware-Komponenten, realisiert werden. Jedenfalls erfüllt die erfindungsgemäße Software bzw. Hardware die Funktionalität, dass ein günstiges Layout eines integrierten Schaltkreises zunächst auf Basis logischer Objekte, d.h. virtuell, derart ermittelt wird, dass vorgebbare Kriterien (z.B. eine vorgegebene Integrationsdichte von Bauelementen) erfüllt werden. Die Ermittlung und virtuelle Anordnung solcher logischer Kontaktierungselemente erfolgt in der Regel in einem Rechner. Mittels Steuerns einer Produktionsanlage, die von dem Rechner mit praktisch zu realisierender logischer Layout-Information versorgt wird, wird das Layout fertigungstechnisch realisiert, indem basierend auf den logischen Kontaktierungselementen auf einem Substrat ein integrierter Schaltkreis mit physikalischen Kontaktierungselementen prozessiert wird.

Insbesondere ist erfindungsgemäß ein softwaregesteuertes Auswahlverfahren bereitgestellt, mit dem die Orientierung der längeren ersten Verlaufsrichtung eines beispielsweise rechteckförmigen Kontaktierungselements bezüglich der geometrischen Anordnung des zu kontaktierenden Bauelements basierend auf der geometrischen Umgebung (das heißt benachbarter Schaltkreiselemente bzw. der Struktur innerhalb des zu kontaktierenden Bauelements) ermittelt wird.

Beispielsweise ist das Breite-zu-Längen-Verhältnis bei einem CMOS-Transistor eines Random-Logik-Schaltkreises häufig in der Größenordnung von 5 und mehr. In diesem Fall kann es günstig sein, die lange Verlaufsrichtung des beispielsweise rechteckförmigen Kontaktierungselements parallel zur Haupt-Verlaufsrichtung einer Gate-Leitung (bzw. senkrecht zu einer Verbindungsachse zwischen den beiden Source-/Drain-Bereichen des CMOS-Transistors) auszurichten. Dies kann realisiert werden, ohne dass eine unerwünschte Beeinflussung von angrenzenden Transistoren auftritt, aufgrund des Breite-zu-Längen-Verhältnisses.

Erfindungsgemäß ist somit ein einfaches aber effektives Verfahren geschaffen, das es ermöglicht, Kontaktierungselemente mit rechteckförmigem Querschnitt, insbesondere in Random-Logik-Schaltkreisen zu verwenden.

Daher ist es erfindungsgemäß ermöglicht, in Logikschaltkreisen Kontaktierungselemente mit rechteckförmigen Querschnitten einzusetzen, was aufgrund der mit der Erfindung überwundenen Probleme bisher nicht möglich war.

Ferner können erfindungsgemäß die Vorteile der Verwendung von Kontaktierungselementen mit rechteckförmigem Querschnitt mit der Funktionalität softwaregesteuerter Datenverarbeitungsverfahren kombiniert werden, welche einfach mit dem System der Erfindung implementiert werden können.

Mit der Erfindung sind aufgrund der erhöhten Integrationsdichte bzw. des verringerten Platzbedarfs integrierte Schaltkreise auf kleineren Chips erreichbar, dadurch ist eine höhere Chip-Ausbeute pro Wafer erreicht, und der Mitte-Mitte-Abstand benachbarter Bauelemente bzw. Kontaktierungselemente als limitierender Faktor für die Größe eines Chips kann herabgesetzt werden. Darüber hinaus ist eine Logik-Schaltkreisarchitektur mit schnellerer Signalverarbeitung ermöglicht, da die gesamte Fläche des integrierten Schaltkreises verringert werden kann, wodurch auch kürzere Leiterbahnen und daher verringerte Signallaufzeiten möglich werden.

Gemäß der Erfindung kann anschaulich ein zweistufiges Verfahren zum Ermitteln einer Anordnung von rechteckförmigen Kontaktierungselementen von Bauelementen eines integrierten Schaltkreises durchgeführt werden. In einem ersten Verfahrensabschnitt kann zum Beispiel unter Verwendung eines herkömmlichen Layout-Berechnungsverfahrens zum Ermitteln eines Layouts für einen Halbleiter-Schaltkreis ein Layout für quadratische Kontaktierungselemente ermittelt werden. Anders ausgedrückt wird ein Layout für eine Maske virtuell (d.h. softwaregesteuert) ermittelt, mit der Randbedingung, dass die Kontaktierungselemente zum Kontaktieren der Bauelemente einen quadratischen Querschnitt aufweisen. In einem zweiten Verfahrensabschnitt kann dann die Randbedingung, dass die Kontaktierungselemente quadratisch sein sollen, aufgegeben werden. Das in dem ersten Verfahrensabschnitt ermittelte Layout kann dann als Anfangsmodell für einen im Weiteren durchzuführenden Verfeinerungsschritt zum Berechnen eines verbesserten Layouts verwendet werden. Hierbei werden anschaulich die Seitenlängen der Kontaktierungselemente als freie (Optimierungs-)Parameter angesehen, und es werden somit auch rechteckförmige Kontaktierungselemente für ein im Weiteren zu ermittelndes Layout erlaubt. Der softwaregesteuerte zweite Verfahrensabschnitt, der einen Schwerpunkt der Erfindung darstellt, verbessert das zuvor ermittelte Layout-Modell basierend auf dem Kriterium, dass die rechteckförmigen Kontaktierungselemente mit der Längsrichtung (d.h. in der Richtung mit der größeren Ausdehnung) in derjenigen Richtung angeordnet werden, in welcher der größere Spielraum bzw. die größere Dimensionskontrolle besteht. Es wird sodann mittels einer Software ein entsprechendes Layout berechnet, das heißt, es werden die Daten des Originaldesigns manipuliert. Basierend auf den so ermittelten Layoutdaten, die gegenüber der Verwendung quadratischer Kontaktierungselemente aufgrund der höheren Zahl von Freiheitsgraden verbessert sind, kann dann eine Lithographie-Maske hergestellt werden. Diese Lithographiemaske kann dann dazu verwendet werden, Wafer mittels Projektionslithographie zu belichten und somit das theoretisch ermittelte Layout auf einen Halbleiter-Wafer zu übertragen. Dieser Halbleiter-Wafer enthält dann einen integrierten Schaltkreis, bei dem Bauelemente mit rechteckförmigen Kontaktierungselementen kontaktiert sind. Wenngleich die soeben vorgenommene Beschreibung zum Zwecke der Veranschaulichung basierend auf quadratischen/rechteckigen Kontaktierungselementen vorgenommen worden ist, liegt es im Rahmen der Erfindung, Kontaktierungselemente beliebiger Geometrie für ein Layout-Design zu berechnen, sofern für die berechneten Kontaktierungselemente entlang zweier zueinander orthogonaler Richtungen unterschiedliche Ausdehnungen erlaubt sind. So ist es zum Beispiel möglich, dass erfindungsgemäß aus einem Layout mit Kontaktierungselementen mit kreisförmigem Querschnitt Kontaktierungselemente mit ellipsenförmigem Querschnitt ermittelt werden.

Bevorzugte Weiterbildungen der Erfindung ergeben sich aus den abhängigen Ansprüchen.

Gemäß dem Verfahren kann für zumindest ein Kontaktierungselement ein im Wesentlichen rechteckförmiger Querschnitt verwendet werden, wobei die dritte Verlaufsrichtung des Kontaktierungselements parallel zu der längeren Rechteckseite, und wobei die vierte Verlaufsrichtung des Kontaktierungselements parallel zu der kürzeren Rechteckseite verläuft.

Wenngleich die Verwendung eines Kontaktierungselements mit rechteckförmigem Querschnitt besonders vorteilhaft ist, ist auch ein Kontaktierungselement mit einem von einem rechteckförmigen Querschnitt abweichendem Querschnitt möglich. So kann beispielsweise ein Kontaktierungselement mit einem ellipsenförmigen oder vieleckförmigen Querschnitt verwendet werden.

Auch kann ein Kontaktierungselement mit einem geometrisch unregelmäßigem bzw. kompliziertem Querschnitt verwendet werden, beispielsweise um a priori bekannte Maskenfehler auszugleichen. Ist beispielsweise bekannt, dass aufgrund von optischen Abbildungsfehlern ein rechteckförmiger Soll-Querschnitt auf der Maskenebene zu einem physikalischen Kontaktierungselement mit einem ellipsenförmigen Querschnitt auf dem Halbleiterchip führt, so kann diese bekannte Abbildungsabweichung kompensiert werden, indem in der Maske ein Kontaktierungselement mit einem geeignet gewählten Querschnitt vorgesehen ist, so dass das physikalische Kontaktierungselement auf der Oberfläche des integrierten Schaltkreises unter Berücksichtigung der Verzerrung rechteckförmig ist.

Ferner kann das Kontaktierungselement basierend auf der Umgebung des zugeordneten Bauelements in dem integrierten Schaltkreis, insbesondere basierend auf den in der Umgebung angeordneten benachbarten Bauelementen, angeordnet werden.

Das Kontaktierungselement kann basierend auf dem Kriterium angeordnet werden, dass der Flächenbedarf des integrierten Schaltkreises verringert wird, was hinsichtlich des Materialverbrauchs, der Tendenz zur Miniaturisierung und des Bedarfs an Schaltkreisen mit schneller Signalverarbeitung vorteilhaft ist.

Ferner kann das Kontaktierungselement basierend auf dem Kriterium angeordnet werden, dass der Abstand benachbarter Bauelemente voneinander verringert wird.

Das Kontaktierungselement wird vorzugsweise basierend auf dem Kriterium angeordnet, dass eine unerwünschte Beeinflussung zwischen benachbarten Bauelementen und/oder zwischen benachbarten Kontaktierungselementen eines Bauelements vermieden wird. Das Vermeiden von Übersprechen ("cross talk") zwischen benachbarten Bauelementen kann als Kriterium beim Ermitteln der geometrischen Anordnung der Kontaktierungselemente berücksichtigt werden.

Das Kontaktierungselement kann basierend auf dem Kriterium angeordnet werden, dass die Geschwindigkeit, insbesondere eine Signalverarbeitungsgeschwindigkeit, des integrierten Schaltkreises erhöht bzw. maximiert wird.

Die Länge der Rechteckseiten des Kontaktierungselements mit rechteckförmiger Querschnittsfläche werden vorzugsweise derart ermittelt, dass der Flächenbedarf des integrierten Schaltkreises und/oder der Abstand benachbarter Bauelemente voneinander verringert wird.

Mit anderen Worten kann gemäß dem erfindungsgemäßen Optimierungsverfahren die Anordnung eines integrierten Bauelements auch so ermittelt werden, dass die Dimensionen der Rechteckseiten des Kontaktierungselements als Variable angesehen werden, die verändert und auf die Bedürfnisse des integrierten Schaltkreises angepasst werden können.

Der integrierte Schaltkreis kann mindestens zwei unterschiedliche Typen von Bauelementen aufweisen. Insbesondere kann der integrierte Schaltkreis einen Logikschaltkreis enthalten oder ein Logikschaltkreis, insbesondere ein Random-Logik-Schaltkreis, sein.

Bei einem Random-Logik-Schaltkreis treten häufig komplizierte und wenig regelmäßige Abfolgen von unterschiedlichen integrierten Bauelementen auf, so dass dem gezielten Anordnen rechteckförmiger Kontaktierungselemente in Random-Logik-Schaltkreisen besondere Bedeutung zukommt. Dies ist erfindungsgemäß ermöglicht, ohne dass der Mitte-Mitte-Abstand benachbarter Bauelemente bzw. benachbarter Kontaktierungselemente dadurch negativ beeinflusst wird.

Ferner kann bei dem Verfahren mindestens eines der Bauelemente ein Feldeffekttransistor sein, und die Kontaktierungselemente können zum Kontaktieren der Source-/Drain-Bereiche des mindestens einen Feldeffekttransistors vorgesehen sein. Gemäß dem Verfahren wird die längere Rechteckseite des Kontaktierungselements als im Wesentlichen parallel zu einer Verlaufsrichtung einer Gate-Leitung verlaufend angeordnet. Die kürzere Rechteckseite des Kontaktierungselements kann als im Wesentlichen parallel zu der Verbindungsachse der beiden Source-/Drain-Bereiche verlaufend angeordnet sein.

Das Bauelement kann allerdings nicht nur ein Feldeffekttransistor (insbesondere ein MOSFET) sein, sondern kann ein Bipolar-Transistor, eine Diode, eine Speicherzelle (beispielsweise Floating-Gate-Speicherzelle), ein Logikgatter, ein Kondensator, ein ohmscher Widerstand, eine Spule etc. sein.

Gemäß dem Verfahren kann ferner für jedes der Bauelemente die geometrische Anordnung des Schwerpunkts jedes der zugehörigen Kontaktierungselemente ermittelt werden, und es können die beiden Seitenlängen des rechteckförmigen Querschnitts jedes der zugehörigen Kontaktierungselemente ermittelt werden.

Beispielsweise kann zunächst ein Kontaktierungselement mit einem quadratischen Querschnitt an einem geeigneten Ort auf einem Layout-Entwurf für ein später auszubildendes Bauelement eines später auszubildenden integrierten Schaltkreises angeordnet werden. Das Layout existiert zu diesem Zeitpunkt in der Regel nur als Software-Komponente, nicht hingegen realisiert auf einem Wafer. Ein zusätzliches Softwaremodul kann dann in dem Layout das Kontaktierungselement mit quadratischem Querschnitt zu einem rechteckförmigen Querschnitt verzerren, wobei die Seitenlängen des dann rechteckförmigen virtuellen Kontaktierungselements vorzugsweise so gewählt werden können, dass die lange Achse so angeordnet wird, dass eine bestmögliche CD-Steuerung (critical dimension) ermöglicht ist. Basierend auf einem solchen verbesserten Layout kann dann ein Wafer mit rechteckförmigen Kontaktierungselementen prozessiert werden

Zusammenfassend ist erfindungsgemäß ein neuartiges Kontaktloch-Design, insbesondere für Random-Logik-Halbleiter-Schaltkreise geschaffen.

Es ist anzumerken, dass alle Ausgestaltungen, die bezugnehmend auf das erfindungsgemäße Verfahren zum Anordnen von Kontaktierungselementen von Bauelementen eines integrierten Schaltkreises beschrieben sind, auch für die erfindungsgemäße Vorrichtung, das Computerlesbare Speichermedium und das Programm-Element gelten.

Insbesondere kann die Erfindung besonders vorteilhaft in Logik-Schaltkreisen verwendet werden.

Ausführungsbeispiele der Erfindung sind in den Figuren dargestellt und werden im Weiteren näher erläutert.

Es zeigen:
- Fig.1: eine Querschnittsansicht eines integrierten Schaltkreises,
- Fig.2: eine erste Layout-Ansicht eines zu gestaltenden integrierten Schaltkreises zu einem ersten Zeitpunkt während des Anordnens von Kontaktierungselementen gemäß der Erfindung,
- Fig.3: eine zweite Layout-Ansicht des zu gestaltenden Schaltkreises zu einem anderen Zeitpunkt während des erfindungsgemäßen Anordnens von Kontaktierungselementen;
- Fig.4A: ein Flussdiagramm eines Verfahrens zum Anordnen von Kontaktierungselementen von Bauelementen eines integrierten Schaltkreises gemäß einem Ausführungsbeispiel der Erfindung;
- Fig.4B: eine Lithographie-Einrichtung zum Prozessieren von Wafern gemäß einer erfindungsgemäß ermittelten Anordnung von Kontaktierungselementen von Bauelementen eines integrierten Schaltkreises.

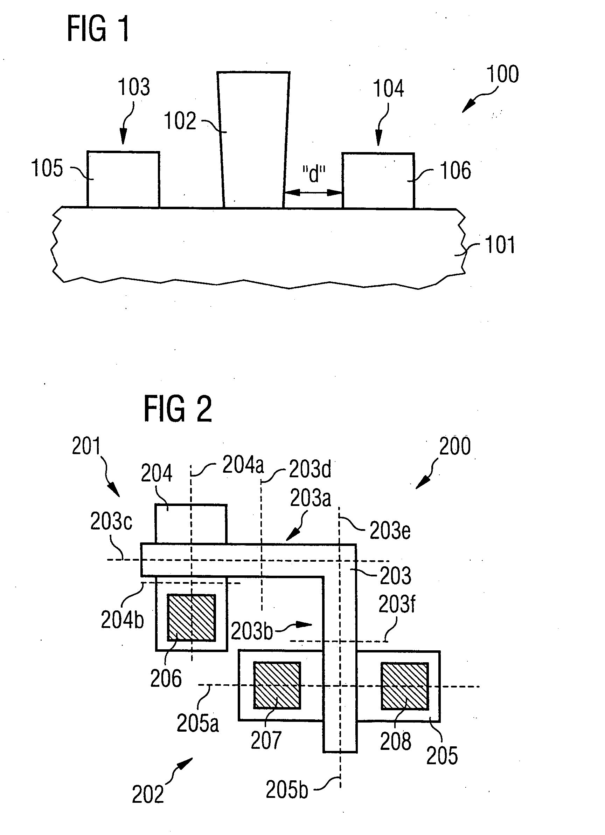

Im Weiteren wird bezugnehmend auf **Fig.1** der integrierte Schaltkreis 100 beschrieben.

Dieser zeigt ein Silizium-Substrat 101, auf bzw. in dem ein erster Feldeffekttransistor 103 als erstes Bauelement und ein zweiter Feldeffekttransistor 104 als zweites Bauelement integriert sind. Die Komponenten der Feldeffekttransistoren 103, 104 sind in Fig.1 nur teilweise gezeigt, insbesondere ist der Gate-Bereich 105 bzw. der Gate-Bereich 106 der Feldeffekttransistoren 103, 104 gezeigt. Zwischen den Feldeffekttransistoren 103, 104 ist ein Kontaktierunaselement 102 angeordnet. Das Kontaktierungselement 102 ist von dem Gate-Bereich 106 des zweiten Feldeffekttransistors 104 in einem Abstand "d" angeordnet, der einen kritischen (Mindest-) Abstand nicht unterschreiten soll. Falls das Kontaktierungselement 102 bezüglich der Feldeffekttransistoren 103, 104 fehlerhaft (insbesondere zu dicht benachbart) angeordnet ist, so hat dies eine unerwünschte Wechselwirkung zwischen einzelnen Bauelementen zur Folge. Insbesondere ist dann nicht auszuschließen, dass mittels des Kontaktierungselements 102 integrierte Bauelemente irrtümlich kontaktiert werden können, was die Funktionalität des integrierten Schaltkreises 100 negativ beeinflussen kann. Wird der Abstand zwischen benachbarten Bauelementen sehr groß gewählt, so geht wertvoller Oberflächenbereich des Silizium-Substrats 101 nutzlos verloren. Daher kommt der zielgenauen Anordnung des Kontaktierungselements in dem integrierten Schaltkreis 100 maßgebliche Bedeutung zu.

Im Weiteren wird bezugnehmend auf **Fig.2** eine erste Layout-Ansicht 200 für einen integrierten Schaltkreis beschrieben, wie er zu einem ersten Zeitpunkt während des erfindungsgemäßen Verfahrens zum Ermitteln einer Anordnung von Kontaktierungselementen gemäß einem Ausführungsbeispiel der Erfindung erhalten wird.

Zunächst ist anzumerken, dass die in Fig.2 gezeigte Layout-Ansicht 200 nicht tatsächlich auf einem Halbleiter-Substrat prozessiert ist, sondern ein mittels einer Software zum Erstellen eines Layout-Designs für einen integrierten Halbleiter-Schaltkreis erstelltes Layout darstellt, d.h. ein logisches und kein physikalisches Objekt darstellt.

Das Layout-Design eines integrierten Schaltkreises 200 hat einen ersten Feldeffekttransistor 201 und einen zweiten Feldeffekttransistor 202, die eine gemeinsame Gate-Leitung 203 zum Kontaktieren der Gate-Bereiche der Feldeffekttransistoren 201, 202 aufweisen. Bei dem in Fig.2 gezeigten Layout-Design eines integrierten Schaltkreises 200 ist die gemeinsame Gate-Leitung 203 als winkelförmiges (rechtwinkliges) Element vorgesehen, das eine erste Gate-Komponente 203a zum Steuern des ersten Feldeffekttransistors 201 und eine zu der ersten Gate-Komponente 203a orthogonale zweite Gate-Komponente 203b zum Steuern des zweiten Feldeffekttransistors 202 enthält. Die erste Gate-Komponente 203a erstreckt sich in dem Layout-Design entlang einer ersten Verlaufsrichtung 203c sowie entlang einer dazu orthogonalen zweiten Verlaufsrichtung 203d, wobei deren Ausdehnung in Richtung der ersten Verlaufsrichtung 203c erheblich größer ist als in Richtung der zweiten Verlaufsrichtung 203d. Die zweite Gate-Komponente 203b erstreckt sich entlang einer dritten Verlaufsrichtung 203e sowie entlang einer dazu orthogonalen vierten Verlaufsrichtung 203f, wobei deren Ausdehnung in Richtung der dritten Verlaufsrichtung 203e erheblich größer ist als in Richtung der vierten Verlaufsrichtung 203f. Ferner ist für den ersten Feldeffekttransistor 201 schematisch ein aktives Gebiet 204 gezeigt, das im Wesentlichen die beiden Source-/Drain-Bereiche und den Kanal-Bereich des Feldeffekttransistors 201 repräsentiert. Das aktive Gebiet 204 als Teil des ersten Feldeffekttransistors 201 des Layout-Design eines integrierten Schaltkreises 200 erstreckt sich entlang einer ersten Verlaufsrichtung 204a sowie entlang einer dazu orthogonalen zweiten Verlaufsrichtung 204b. Wie in Fig.2 gezeigt, weist das aktive Gebiet 204 entlang der ersten Verlaufsrichtung 204a eine größere Ausdehnung auf als entlang der zweiten Verlaufsrichtung 204b. Von dem zweiten Feldeffekttransistor 202 ist in Fig.2 das aktive Gebiet 205 schematisch gezeigt, das die beiden Source-/Drain-Bereiche und den Kanal-Bereich aufweist. Das aktive Gebiet 205 erstreckt sich entlang einer ersten Verlaufsrichtung 205a und entlang einer dazu orthogonalen zweiten Verlaufsrichtung 205b. Wie in Fig.2 gezeigt, ist die Ausdehnung des aktiven Gebiets 205 entlang der ersten Verlaufsrichtung 205a größer als entlang der zweiten Verlaufsrichtung 205b.

Ferner sind in Fig.2 ein erstes quadratisches Kontaktierungselement 206 zum Kontaktieren eines Source-/Drain-Bereichs des ersten Feldeffekttransistors 201 gezeigt. Darüber hinaus sind zweite und dritte quadratische Kontaktierungselemente 207, 208 zum Kontaktieren der Source-/Drain-Bereiche (nicht gezeigt) des zweiten Feldeffekttransistors 202 gezeigt.

Alle Komponenten des Layout-Design eines integrierten Schaltkreises 200 (insbesondere die quadratischen Kontaktierungselemente 206 bis 208) sind virtuell, d.h. Software-Elemente, und nicht bereits auf einem Wafer ausgebildete Komponenten.

Die gemäß einer ersten Verfahrensstufe des erfindungsgemäßen Verfahren ermittelte Anordnung der quadratischen Kontaktierungselemente 206 bis 208 erfolgt derart, dass die geometrische Anordnung des Schwerpunkte der Kontaktierungselemente 206 bis 208 so ermittelt wird, dass der Flächenbedarf des integrierten Schaltkreises ausreichend gering ist, dass der Abstand benachbarter Bauelemente bzw. benachbarter Kontaktierungselemente voneinander ausreichend gering ist, dass eine unerwünschte Beeinflussung zwischen benachbarten Bauelementen bzw. zwischen benachbarten Kontaktierungselementen vermieden ist und dass die (simulierte bzw. basierend auf einem theoretischen Modell berechnete) Geschwindigkeit des integrierten Schaltkreises gemäß dem Layout-Design 200 ausreichend hoch ist.

Randbedingung bei dem Verfahren zum Berechnen des Layout-Designs eines integrierten Schaltkreises 200 ist, dass die Kontaktierungselemente 206 bis 208 einen quadratischen Querschnitt aufweisen sollen.

In einem weiteren Verfahrensschritt wird erfindungsgemäß das in Fig.2 gezeigte Layout-Design des integrierten Schaltkreises 200 weiter optimiert, da die Verwendung von Kontaktierungselementen 206 bis 208 mit einem quadratischen Querschnitt verbesserungsbedürftig ist. Günstiger ist eine Verwendung von Kontaktierungselementen mit rechteckförmigen Querschnitt, die unterschiedlich lange Seitenlängen aufweisen.

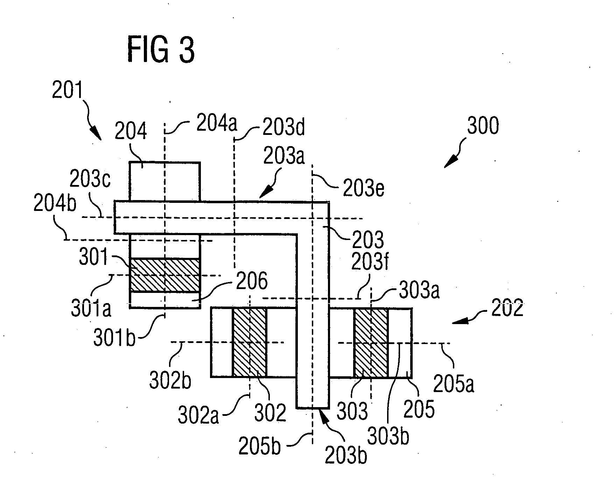

Im Weiteren wird bezugnehmend auf Fig.3 ein Layout-Design eines integrierten Schaltkreises 300 beschrieben, wie es zu einem zweiten Zeitpunkt während des erfindungsgemäßen softwarebasierten Verfahrens zum Anordnen von Kontaktierungselementen von Bauelementen des Layouts für einen integrierten Schaltkreis 300 erhalten wird.

In dieser zweiten Verfahrensstufe wird der quadratische Querschnitt der virtuellen Kontaktierungselemente 206 bis 208 anschaulich zu rechteckförmigen Querschnitten verzerrt, um das Layout des integrierten Schaltkreises weiter zu optimieren. Der wesentliche Unterschied zwischen dem Layout-Design eines integrierten Schaltkreises 200 und dem Layout-Design eines integrierten Schaltkreises 300 besteht somit darin, dass bei dem Layout der Schaltkreis-Anordnung 300 anstelle der Kontaktierungselemente 206 bis 208 mit quadratischem Querschnitt erste bis dritte rechteckförmige Kontaktierungselemente 301 bis 303 vorgesehen sind.

Die Längsrichtung eines jeweiligen Kontaktierungselements 301 bis 303 wird in dem Layout 300 anschaulich derart angeordnet, dass in der Richtung der längeren Ausdehnung eines jeweiligen Kontaktierungselements 301 bis 303 der größere Spielraum bzw. die bessere Dimensionskontrolle besteht.

Das erste rechteckförmige Kontaktierungselement 301, das dem ersten Feldeffekttransistor 201 zugeordnet ist, weist einen rechteckförmigen Querschnitt auf und weist entlang einer dritten Verlaufsrichtung 301a eine größere Ausdehnung auf als entlang einer zu der dritten Verlaufsrichtung 301a orthogonalen vierten Verlaufsrichtung 301b. Ein dem zweiten Feldeffekttransistor 202 zugeordnetes zweites quadratisches Kontaktierungselement 302 erstreckt sich entlang einer dritten Verlausrichtung 302a und entlang einer dazu orthogonalen vierten Verlaufsrichtung 302b, wobei die Ausdehnung des zweiten rechteckförmigen Kontaktierungselements 302 entlang der dritten Verlaufsrichtung 302a größer ist als entlang der vierten Verlaufsrichtung 302b. Entsprechend erstreckt sich ein drittes rechteckförmiges Kontaktierungselement 303, das auch dem zweiten Feldeffekttransistor 302 zugeordnet ist, entlang einer dritten Verlaufsrichtung 303a mit einer größeren Ausdehnung als entlang einer dazu orthogonalen vierten Verlaufsrichtung 303b.

Gemäß dem erfindungsgemäßen Verfahren wird das Layout-Design eines des integrierten Schaltkreises 300, insbesondere die Anordnung der rechteckförmigen und nicht-quadratischen Kontaktierungselemente 301 bis 303 ermittelt, indem die Kontaktierungselemente 301 bis 303 bezüglich des jeweils zugeordneten Bauelements 203a bzw. 203b derart angeordnet werden, dass die erste Verlaufsrichtung 203c der ersten Gate-Komponente 203a zu der dritten Verlaufsrichtung 301a des zugehörigen Kontaktierungselements 301a parallel verläuft. Ferner wird die dritte Verlaufsrichtung 203e der zweiten Gate-Komponente 203b zu den dritten Verlaufsrichtungen 302a und 303a der zugehörigen Kontaktierungselemente 302, 303 parallel verlaufend angeordnet. Auch wird die kürzere Rechteckseite des jeweiligen Kontaktierungselements 301 bis 303 im Wesentlichen parallel zu der Verbindungsachse der beiden Source-/Drain-Bereiche des jeweils zugeordneten Feldeffekttransistors 201 bzw. 202 verlaufend angeordnet. Nachdem das optimierte Layout-Design für einen integrierten Schaltkreis 300 gemäß Fig.3 rechnergestützt ermittelt ist, wird eine Lithographie-Maske basierend auf diesem Layout 300 erstellt. Unter Verwendung einer Projektionslithographie wird unter Verwendung dieser Maske ein Wafer prozessiert, auf welchem dann reale, physikalische Kontaktierungselemente mit rechteckigem Querschnitt ausgebildet sind.

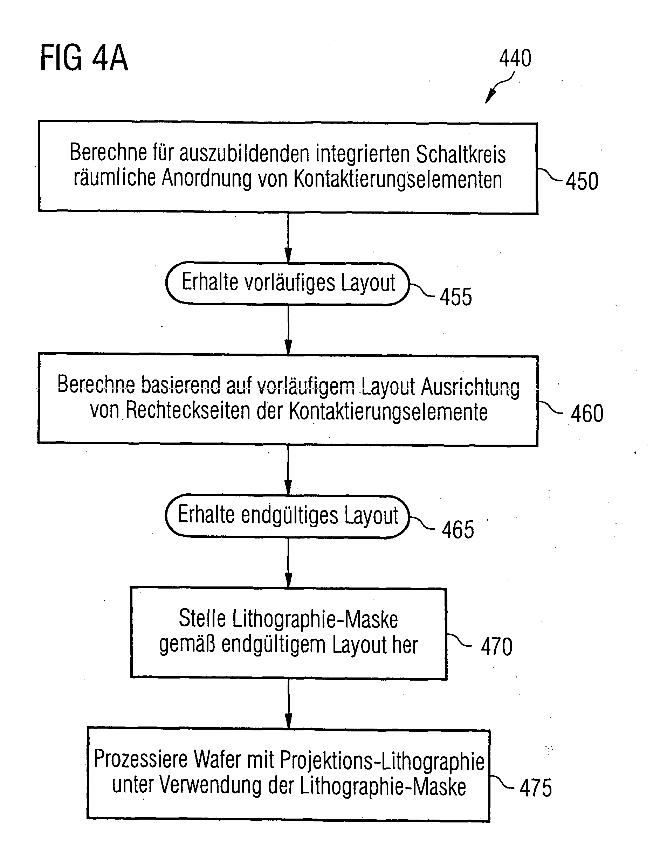

Im Weiteren wird bezugnehmend auf **Fig.4A** ein Flussdiagramm 440 eines Verfahrens zum Anordnen von Kontaktierungselementen von Bauelementen eines integrierten Schaltkreises gemäß einem Ausführungsbeispiel der Erfindung beschrieben.

In einem ersten Verfahrensschritt 450 wird für einen auszubildenden integrierten Schaltkreis eine räumliche Anordnung von Kontaktierungselementen rechnergestützt berechnet. Dies erfolgt unter Verwendung einer Standardsoftware, die gemäß dem beschriebenen Ausführungsbeispiel zum Beispiel die geometrischen Schwerpunkte der Kontaktierungselemente in dem zu entwerfenden Schaltkreis ermittelt. Alternativ kann die Standardsoftware eine Anordnung von quadratischen Kontaktierungselementen berechnen.

In einem zweiten Verfahrensschritt 455 wird dann als Ergebnis von Verfahrensschritt 450 ein vorläufiges Layout für den zu gestaltenden integrierten Schaltkreis erhalten, welches Layout auch eine vorläufige Anordnung von quadratischen Kontaktierungselementen enthält.

In einem dritten Verfahrensschritt 460 wird basierend auf bzw. ausgehend von dem erhaltenen vorläufigen Layout eine verbesserte Anordnung der Kontaktierungselemente softwaregestützt berechnet. Verfahrensschritt 460 ist Kernstück des erfindungsgemäßen Verfahrens. Anschaulich wird die in Verfahrensschritt 450 getroffene Annahme, dass die Kontaktierungselemente quadratischen Querschnitt aufweisen, in Schritt 460 aufgegeben, und es wird eine Rechteckform von Kontaktierungselementen zugelassen. Die Rechteckseiten der Kontaktierungselemente werden mit der längeren Seite in diejenige Richtung auf dem Schaltkreis-Layout ausgerichtet, in welcher der größte geometrische Spielraum besteht. Ferner können in diesem Verfahrensschritt die Dimensionen der Rechteckseiten verändert (optimiert) werden, z.B. unter Verwendung einer Fit-Routine.

In einem vierten Verfahrensschritt 465 wird dann als Ergebnis von Verfahrensschritt 460 ein endgültiges Layout für den zu gestaltenden integrierten Schaltkreis erhalten, welches endgültige Layout auch eine endgültige, d.h. optimierte, Anordnung von rechteckigen Kontaktierungselementen enthält.

In einem fünften Verfahrensschritt 470 wird eine Lithographie-Maske gemäß dem berechneten endgültigen Layout hergestellt.

In einem sechsten Verfahrensschritt 475 werden dann Halbleiter-Wafer zum Herstellen eines integrierten Schaltkreises gemäß dem endgültigen Layout einem Projektions-Lithographie-Verfahren unterworfen, wobei die in Verfahrensschritt 470 hergestellte Lithographie-Maske zum Ausbilden eines integrierten Schaltkreises auf einem jeweiligen Wafer verwendet wird.

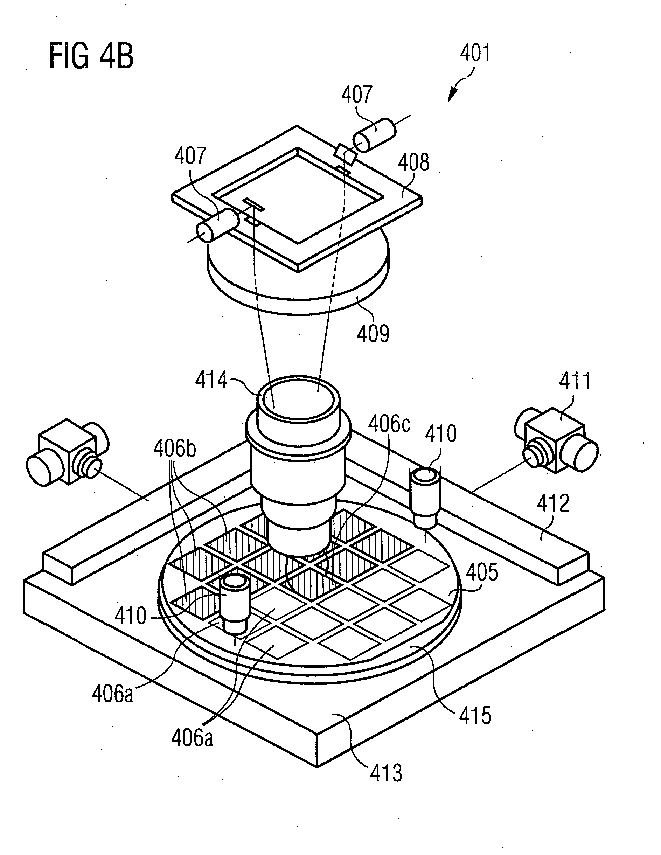

Im Weiteren wird bezugnehmend auf **Fig.4B** eine Lithographie-Einrichtung 401 zum Prozessieren von Wafern gemäß des entsprechend Fig.4A ermittelten endgültigen Layouts eines integrierten Schaltkreises beschrieben.

Mittels der Lithographie-Einrichtung 401 werden Chips 406a, 406b eines Silizium-Wafers 405 derart prozessiert, dass auf den Chips 406a, 406b eine Belichtung entsprechend der in Verfahrensschritt 470 von Fig.4A hergestellten Maske als Teilschritt zum Ausbilden eines integrierten Schaltkreises durchgeführt wird. Hierzu wird der Silizium-Wafer 405 zunächst auf einem Träger-Element 415 angeordnet, das wiederum auf einem xy-Tisch angeordnet ist. Unter Verwendung einer Vorjustier-Optik 410 sowie einer Justieroptik 407 wird ein jeweils zu prozessierender Chip (gemäß dem Szenario von Fig.4B der zu prozessierende Chip 406c) bezüglich eines Belichtungssystems ausgerichtet. Das Belichtungssystem enthält ein Retikel 408 (d.h. die in Verfahrensschritt 470 von Fig.4A hergestellte Maske), eine Linse 409 und eine nicht gezeigte Lichtquelle (z.B. einen Laser), mittels der Licht durch die Anordnung aus Retikel 408, Linse 409 und Objektiv 414 entsprechend einer Maske mit vorgegebenem Strukturierungsmuster auf den jeweils zu prozessierenden Chip 406c des Wafers 405 eingestrahlt werden kann. Mittels einer Abtastmechanik kann das System selektiv jeden der Chips 406a, 406b, 406c belichten. Das selektive Anfahren einer lateralen Tischposition erfolgt mit Hilfe eines Laserinterferometers 411 und einer Spiegelfläche 412.

Gemäß dem in Fig.4 gezeigten Szenario sind die Chips 406a bereits prozessiert, das heißt entsprechend der Maske belichtet, wohingegen die unprozessierten Chips 406b noch nicht belichtet sind.

Es ist anzumerken, dass vor dem Belichten der Chips 406a, 406b auf diese eine Photoresist-Schicht (nicht gezeigt) aufgebracht wird, wobei das Photoresist-Material derart eingerichtet ist, dass es nach dem Belichten mittels eines Ätz-Verfahrens entfernbar ist, wohingegen unbelichtetes Photoresist-Material vor einem Entfernen mittels Ätzens geschützt ist. Nach dem Belichten wird der Wafer 405 daher einem Ätz-Verfahren unterzogen, um die gewünschte Strukturierung der Chips zu realisieren.

Die photolithographische Strukturierung der Chips 406 des Silizium-Wafers 405 erfolgt, um auf jedem der Chips 406 einen integrierten Schaltkreis mit Bauelementen mit rechteckigen Kontaktierungselementen entsprechend dem in Fig.4A ermittelten endgültigen Layout auszubilden.

Basierend auf dem in Verfahrensschritt 465 theoretisch berechneten endgültigen Layout, d.h. basierend auf den logischen Kontaktierungselement-Objekten, werden physikalische, das heißt materielle Kontaktierungselemente auf den Chips 406a, 406b, 406c des Halbleiter-Wafers 405 ausgebildet.
Es ist anzumerken, dass das Ausbilden der Kontaktierungselemente neben der Lithographie-Einrichtung 401 weitere Einrichtungen zum Beispiel zum Abscheiden und Ätzen von Photoresist bzw. Material für die Kontaktierungselemente erfordert.

In diesem Dokument sind folgende Veröffentlichungen zitiert:
[1] http://www.tok.co.jp/tech/carl_top-e.html (Stand: 7. Mai 2002)
[2] http://www.melco.co.jp/rd_home/map/crl/topics/t02e.html (Stand: 7. Mai 2002)
[3] US 2001/0024758 A1
[4] US 5,920,083 A
[5] DE 101 26 130 A1

### Bezugszeichenliste

- 100: integrierter Schaltkreis
- 101: Silizium-Substrat
- 102: Kontaktierungselement
- 103: erster Feldeffekttransistor
- 104: zweiter Feldeffekttransistor
- 105: Gate-Bereich
- 106: Gate-Bereich
- 200: erste Layout-Ansicht eines integrierten Schaltkreises
- 201: erster Feldeffekttransistor
- 202: zweiter Feldeffekttransistor
- 203: gemeinsame Gate-Leitung
- 203a: erste Gate-Komponente
- 203b: zweite Komponente
- 203c: erste Verlaufsrichtung
- 203d: zweite Verlaufsrichtung
- 203e: dritte Verlaufsrichtung
- 203f: vierte Verlaufsrichtung
- 204: aktives Gebiet
- 204a: erste Verlaufsrichtung
- 204b: zweite Verlaufsrichtung
- 205: aktives Gebiet
- 205a: erste Verlaufsrichtung
- 205b: zweite Verlaufsrichtung
- 206: erstes quadratisches Kontaktierungselement
- 207: zweites quadratisches Kontaktierungselement
- 208: drittes quadratisches Kontaktierungselement
- 300: zweite Layout-Ansicht eines integrierten Schaltkreises
- 301: erstes rechteckförmiges Kontaktierungselement
- 301a: dritte Verlaufsrichtung
- 301b: vierte Verlaufsrichtung
- 302: zweites rechteckförmiges Kontaktierungselement
- 302a: dritte Verlaufsrichtung
- 302b: vierte Verlaufsrichtung
- 303: drittes rechteckförmiges Kontaktierungselement
- 303a: dritte Verlaufsrichtung
- 303b: vierte Verlaufsrichtung
- 401: Lithographie-Einrichtung
- 405: Silizium-Wafer
- 406a: prozessierte Chips
- 406b: unprozessierte Chips
- 406c: zu prozessierender Chip
- 407: Justieroptik
- 408: Retikel
- 409: Linse
- 410: Vorjustieroptik
- 411: Laserinterferometer
- 412: Spiegelfläche
- 413: xy-Tisch
- 414: Objektiv
- 415: Träger-Element
- 440: Flussdiagramm
- 450: erster Verfahrensschritt
- 455: zweiter Verfahrensschritt
- 460: dritter Verfahrensschritt
- 465: vierter Verfahrensschritt
- 470: fünfter Verfahrensschritt
- 475: sechster Verfahrensschritt

## Patentansprüche

1. Verfahren zum Anordnen von Kontaktierungselementen von Bauelementen eines integrierten Schaltkreises, wobei zumindest ein Teil von zumindest einem Bauelement entlang einer ersten Verlaufsrichtung eine größere Ausdehnung aufweist als entlang einer zu der ersten Verlaufsrichtung orthogonalen zweiten Verlaufsrichtung, wobei zumindest ein einem Bauelement zugeordnetes Kontaktierungselement im Querschnitt entlang einer dritten Verlaufsrichtung eine größere Ausdehnung aufweist als entlang einer zu der dritten Verlaufsrichtung orthogonalen vierten Verlaufsrichtung,
bei dem das Kontaktierungselement bezüglich des zugeordneten Bauelements derart angeordnet wird, dass die erste Verlaufsrichtung des Bauelements zu der dritten Verlaufsrichtung des Kontaktierungselements im Wesentlichen parallel verläuft,
wobei zunächst ein erstes Layout unter der Annahme von Kontaktierungselementen mit quadratischem Querschnitt ermittelt wird,
wobei basierend auf dem ersten Layout ein zweites Layout mit Kontaktierungselementen mit rechteckigem Querschnitt ermittelt wird.

2. Verfahren nach Anspruch 1,
bei dem das Kontaktierungselement ferner basierend auf der Umgebung des zugeordneten Bauelements in dem integrierten Schaltkreis angeordnet wird.

3. Verfahren nach Anspruch 1 oder 2,
bei dem das Kontaktierungselement basierend auf dem Kriterium angeordnet wird, dass der Flächenbedarf des integrierten Schaltkreises verringert wird.

4. Verfahren nach einem der Ansprüche 1 bis 3,
bei dem das Kontaktierungselement basierend auf dem Kriterium angeordnet wird, dass der Abstand benachbarter Bauelemente voneinander verringert wird.

5. Verfahren nach einem der Ansprüche 1 bis 4,
bei dem das Kontaktierungselement basierend auf dem Kriterium angeordnet wird, dass eine unerwünschte Beeinflussung zwischen benachbarten Bauelementen und/oder zwischen benachbarten Kontaktierungselementen eines Bauelements vermieden wird.

6. Verfahren nach einem der Ansprüche 1 bis 5,
bei dem das Kontaktierungselement basierend auf dem Kriterium angeordnet wird, dass die Geschwindigkeit des integrierten Schaltkreises erhöht wird.

7. Verfahren nach einem der Ansprüche 1 bis 6,
bei dem die Längen der Rechteckseiten des Kontaktierungselements mit rechteckförmiger Querschnittsfläche derart ermittelt werden, dass der Flächenbedarf des integrierten Schaltkreises und/oder der Abstand benachbarter Bauelemente voneinander verringert wird.

8. Verfahren nach einem der Ansprüche 1 bis 7,
bei dem der integrierte Schaltkreis mindestens zwei unterschiedliche Typen von Bauelementen aufweist.

9. Verfahren nach einem der Ansprüche 1 bis 8,
bei dem der integrierte Schaltkreis einen Logik-Schaltkreis enthält oder ein Logik-Schaltkreis ist.

10. Verfahren nach einem der Ansprüche 1 bis 8,
bei dem
• mindestens eines der Bauelemente ein Feldeffekttransistor ist;
• Kontaktierungselemente zum Kontaktieren der Source-/Drain-Bereiche des mindestens einen Feldeffekttransistors vorgesehen sind;
• die kürzere Rechteckseite des Kontaktierungselements als im Wesentlichen parallel zu der Verbindungsachse der beiden Source-/Drain-Bereiche verlaufend angeordnet wird.

11. Verfahren nach einem der Ansprüche 1 bis 8,
bei dem
• mindestens eines der Bauelemente ein Feldeffekttransistor ist;
• Kontaktierungselemente zum Kontaktieren der Source-/Drain-Bereiche des mindestens einen Feldeffekttransistors vorgesehen sind;
• die längere Rechteckseite des Kontaktierungselements als im Wesentlichen parallel zu einer Verlaufsrichtung einer Gate-Leitung verlaufend angeordnet wird.

12. Verfahren nach einem der Ansprüche 1 bis 11,
bei dem für jedes der Bauelemente
• die geometrische Anordnung des Schwerpunkts jedes der zugehörigen Kontaktierungselemente ermittelt wird;
• die beiden Seitenlängen jedes der zugehörigen Kontaktierungselemente mit rechteckförmigem Querschnitt ermittelt werden.

13. Vorrichtung zum Anordnen von Kontaktierungselementen von Bauelementen eines integrierten Schaltkreises, wobei zumindest ein Teil von zumindest einem Bauelement entlang einer ersten Verlaufsrichtung eine größere Ausdehnung aufweist als entlang einer zu der ersten Verlaufsrichtung orthogonalen zweiten Verlaufsrichtung, wobei zumindest ein einem Bauelement zugeordnetes Kontaktierungselement im Querschnitt entlang einer dritten Verlaufsrichtung eine größere Ausdehnung aufweist als entlang einer zu der dritten Verlaufsrichtung orthogonalen vierten Verlaufsrichtung,
mit einem Prozessor, der derart eingerichtet ist, dass folgende Verfahrensschritte durchführbar sind:
das Kontaktierungselement wird bezüglich des zugeordneten Bauelements derart angeordnet, dass die erste Verlaufsrichtung des Bauelements zu der dritten Verlaufsrichtung des Kontaktierungselements im Wesentlichen parallel verläuft, wobei
zunächst ein erstes Layout unter der Annahme von Kontaktierungselementen mit quadratischem Querschnitt ermittelt wird,
basierend auf dem ersten Layout ein zweites Layout mit Kontaktierungselementen mit rechteckigem Querschnitt ermittelt wird.

14. Computerlesbares Speichermedium, in dem ein Programm zum Anordnen von Kontaktierungselementen von Bauelementen eines integrierten Schaltkreises, wobei zumindest ein Teil von zumindest einem Bauelement entlang einer ersten Verlaufsrichtung eine größere Ausdehnung aufweist als entlang einer zu der ersten Verlaufsrichtung orthogonalen zweiten Verlaufsrichtung, wobei zumindest ein einem Bauelement zugeordnetes Kontaktierungselement im Querschnitt entlang einer dritten Verlaufsrichtung eine größere Ausdehnung aufweist als entlang einer zu der dritten Verlaufsrichtung orthogonalen vierten Verlaufsrichtung, gespeichert ist, das, wenn es von einem Prozessor ausgeführt wird, folgende Verfahrensschritte aufweist:
das Kontaktierungselement wird bezüglich des zugeordneten Bauelements derart angeordnet, dass die erste Verlaufsrichtung des Bauelements zu der dritten Verlaufsrichtung des Kontaktierungselements im Wesentlichen parallel verläuft, wobei
zunächst ein erstes Layout unter der Annahme von Kontaktierungselementen mit quadratischem Querschnitt ermittelt wird,
basierend auf dem ersten Layout ein zweites Layout mit Kontaktierungselementen mit rechteckigem Querschnitt ermittelt wird.

15. Programm-Element zum Anordnen von Kontaktierungselementen von Bauelementen eines integrierten Schaltkreises, wobei zumindest ein Teil von zumindest einem Bauelement entlang einer ersten Verlaufsrichtung eine größere Ausdehnung aufweist als entlang einer zu der ersten Verlaufsrichtung orthogonalen zweiten Verlaufsrichtung, wobei zumindest ein einem Bauelement zugeordnetes Kontaktierungselement im Querschnitt entlang einer dritten Verlaufsrichtung eine größere Ausdehnung aufweist als entlang einer zu der dritten Verlaufsrichtung orthogonalen vierten Verlaufsrichtung, das, wenn es von einem Prozessor ausgeführt wird, folgende Verfahrensschritte aufweist:
das Kontaktierungselement wird bezüglich des zugeordneten Bauelements derart angeordnet, dass die erste Verlaufsrichtung des Bauelements zu der dritten Verlaufsrichtung des Kontaktierungselements im Wesentlichen parallel verläuft, wobei
zunächst ein erstes Layout unter der Annahme von Kontaktierungselementen mit quadratischem Querschnitt ermittelt wird,
basierend auf dem ersten Layout ein zweites Layout mit Kontaktierungselementen mit rechteckigem Querschnitt ermittelt wird.
